Europäisches Patentamt

European Patent Office

Office européen des brevets

(11) Publication number: **0 291 952 B1**

# EUROPEAN PATENT SPECIFICATION

(45) Date of publication of patent specification: **17.08.94**  (51) Int. Cl.⁵: **C23C 14/56**, F16J 15/16, C21D 9/56

(21) Application number: **88107959.4**

(22) Date of filing: **18.05.88**

The file contains technical information submitted after the application was filed and not included in this specification

(54) **Differential pressure sealing apparatus and method.**

(30) Priority: **20.05.87 JP 121016/87**
**25.06.87 JP 156457/87**
**05.08.87 JP 194499/87**
**18.03.88 JP 63704/88**

(43) Date of publication of application:
**23.11.88 Bulletin 88/47**

(45) Publication of the grant of the patent:
**17.08.94 Bulletin 94/33**

(84) Designated Contracting States:
**DE FR**

(56) References cited:
**FR-A- 2 163 512**
**US-A- 289 026**
**US-A- 2 972 330**

**PATENT ABSTRACTS OF JAPAN, vol. 7, no. 244 (M-252)[1389], 28th October 1983; M.KUROKI et al.: "Roller system seal device"; & JP-A-58 131 470**

**PATENT ABSTRACTS OF JAPAN, vol. 4, no. 174 (C-33)[656], 2nd December 1980; S.NISHIKAWA: "Vacuum-sealing device and**

equipment"; & JP-A-55 113 875**

(73) Proprietor: **KAWASAKI STEEL CORPORATION**
**No. 1-28, 1-Chome Kitahonmachi-Dori**
**Chuo-Ku, Kobe-City Hyogo 651 (JP)**

Proprietor: **NIHON SHINKU GIJUTSU KABUSHIKI KAISHA**
**2500, Hagizono**
**Chigasaki City Kanagawa Prefecture (JP)**

(72) Inventor: **Inokuti, Yukio**
**Technical Research Div.**
**Kawasaki Steel Corp.**
**1, Kawasaki-Cho Chibacity Chiba Pref. (JP)**
Inventor: **Ito, Yo**
**Technical Research Div.**
**Kawasaki Steel Corp.**
**1, Kawasaki-Cho Chibacity Chiba Pref. (JP)**

(74) Representative: **Patentanwälte Grünecker, Kinkeldey, Stockmair & Partner**
**Maximilianstrasse 58**
**D-80538 München (DE)**

**Description**

This invention relates to a differential pressure sealing apparatus and method effective for maintaining continuously a plurality of different degrees of vacuum or negative pressure at spaced locations along the length of a continuously moving object such as a sheet metal plate, strip, belt or other work object, all of which are hereinafter and in the claims collectively referred to as an "elongated sheet".

When surface coating of sheet metals is performed by so-called dry plating, using processes such as vacuum deposition, ion plating, sputtering etc., a long thin sheet such as a cold-drawn or hot-drawn steel belt is continuously subjected to a so-called "air-to-air" treatment. In this procedure the degree of vacuum applied to the surface of the sheet is alternately raised and lowered while the elongated sheet reaches the dry plating area by passing through a number of spaced-apart areas having vacuum differences among them. These are hereinafter referred to as "differential pressure chambers". Differential-pressure seals are provided along the path of movement of the sheet which permit the continuous passage of the sheet while maintaining the pressure differences among the respective differential pressure chambers. In this specification a differential-pressure sealing apparatus is described which effectively provides differential-pressure seals without causing damage to the sheet or other work object being processed.

Many proposals have already been made for conducting air-to-air plating procedures for metals. For example, reference is made to US-A-2,384,500; 2,972,330 and 2,996,410, as described in Mitsubishi Juko Giho, Vol. 21 (1984), No. 6, pp. 125-131. With the progress of precision manufacturing technologies in recent years, the practical development of these proposals is proceeding. Among these sealing methods, especially in the reference cited last, the sealing area is enlarged so that the elongated sheet of metal is sandwiched between a pair of rollers with their axes slightly offset in the direction in which the sheet is moving, and the elongated sheet follows along the roller surfaces.

Recently, moreover, in JP-A-62-13572, an attempt has been disclosed in which a seal bar and an adaptor enclosing the sheet material are combined, and the pressure difference is maintained within this enclosure. In either case, however, since the sheet material is sandwiched and compressed between a pair of rollers and made into a sheet passing between them, the treated sheet material undergoes bending and compression stresses on its front and back surfaces, and the tension on the sheet is increased.

These tension forces and the local surface pressures generated have adverse effects on the quality of the product; for example, when the air-to-air method is applied to grain oriented silicon steel sheets, it has been found that the magnetic properties of the plate are caused to deteriorate.

Moreover, in addition to this problem, it has also been indicated recently that when brittle elongated sheets comprising a metal such as the above-mentioned grain oriented silicon steel are treated, breakage of the sheet or plate tends to occur due to contact with the sealing device itself, because of vibration.

It is an object of this invention to provide a differential-pressure sealing apparatus and method which overcomes the foregoing disadvantages, and which is suitable for treatment of elongated sheets by processes including the air-to-air method, and which can produce effective differential-pressure seals without causing the quality of the product to deteriorate or the sheets to break.

The foregoing and other objects of the invention will further become apparent hereinafter and in the drawings of which:

Fig. 1(a) is a view in side section showing one embodiment of the inventive apparatus, the inventive supplemental seal (24,25) being merely illustrated in Figs. 17(a) and 17(b),

Figs. 1(b) and 1(c) are sectional views taken as indicated by the lines and arrows A-A and B-B, respectively,

Figs. 2(a) and 2(b) are diagrammatic views of sealing devices in accordance with this invention and portions thereof, Fig. 2(b) is shown in an inverted position in order more clearly to illustrate important details,

Fig. 3 is a graph showing the effects of magnetic properties in response to changes of wrap contact angle $\theta$ (the ordinate) and the tension in kg/mm$^2$ (the abscissa),

Fig. 4 is a graph showing the relationship between degree of reduction of iron loss of an elongated sheet (ordinate) and surface pressure exerted by the roller seal (abscissa),

Fig. 5(a) is a view in side section of a portion of an apparatus, showing an alternative form of the invention,

Fig. 5(b) is a sectional view taken through the apparatus appearing in Fig. 5(a),

Fig. 5(c) is a view in perspective of a portion of the apparatus of Fig. 5(a),

Fig. 6(a) is a view in side section showing one embodiment of sealing device in accordance with this invention,

Figs. 6(b) and 6(c) are sectional views taken as indicated by the lines and arrows A-A and B-B, respectively,

Fig. 7 is a sectional view taken through a seal according to this invention,

Fig. 8 is an enlarged sectional view showing the manner in which the seal portion of Fig. 6 is maintained according to this invention,

Fig. 9 is a diagrammatic view of a portion of an apparatus comprising an alternative embodiment of this invention,

Fig. 10 is a view in side section showing portions of a still further alternative embodiment of the invention,

Fig. 11 is a fragmentary sectional view showing still another embodiment,

Fig. 12 is an exploded view, taken in perspective, showing still a further alternative embodiment of this invention,

Fig. 13(a) is a fragmentary view in side section showing still a further alternative embodiment of this invention,

Figs. 13(b) and 13(c) are sectional views taken as indicated by the lines and arrows C-C and D-D, respectively,

Fig. 14 is a sectional view of a portion of a further embodiment according to this invention,

Fig. 15 is a sectional view of a portion of a still further modified apparatus in accordance with this invention, and

Figs. 16, 17(a) and 17(b) are enlarged sectional views of the entrance portion of the apparatus showing the inventive supplemental seal.

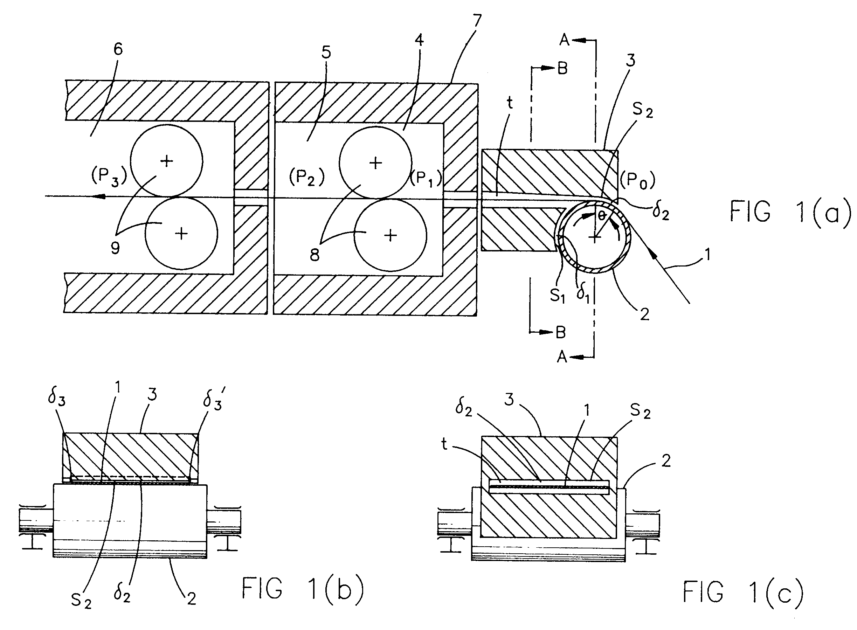

Turning now to the specific forms of the invention selected for illustration in the drawings, the right-hand portion of Fig. 1 shows one form of a differential-pressure sealing apparatus according to this invention, applied in particular to the atmospheric pressure portion of region $P_0$-$P_1$. Vacuum is applied at one or several places to the chamber, as in the US-A-2,972,330, for example. Fig. 1 also shows several spaced areas such as ($P_1$-$P_2$) and ($P_2$-$P_3$) having pressure differences among them. In this figure, the number 1 refers to an elongated sheet moving from right to left as indicated by the arrows. The number 2 refers to a guide roller which guides the elongated sheet 1 as it is conducted into the space 4, and 3 is a sealing attachment, which is an important feature of this invention and which is operative in combination with the guide roller 2. The numbers 4, 5 and 6 designate differential pressure chambers which are constructed so that the degree of vacuum existing in an any given chamber may be increased from atmospheric pressure $P_0$ to the negative pressures $P_1$, $P_2$, $P_3$ ··· increasing in the order of the subscripts, over several spaces with pressure differences, between them, while maintaining the pressure differences continuously as the elongated sheet 1 advances through the treatment method.

On the inner side of a differential-pressure casing 7, which corresponds to a boundary between pressure regions $P_0$-$P_1$, the guide roller 2, is provided on which the elongated sheet 1 is passed.

The elongated sheet 1 is guided on the outside of guide roller 2, preferably at a wrap contact angle $\theta$ - (Fig. 1(a)).

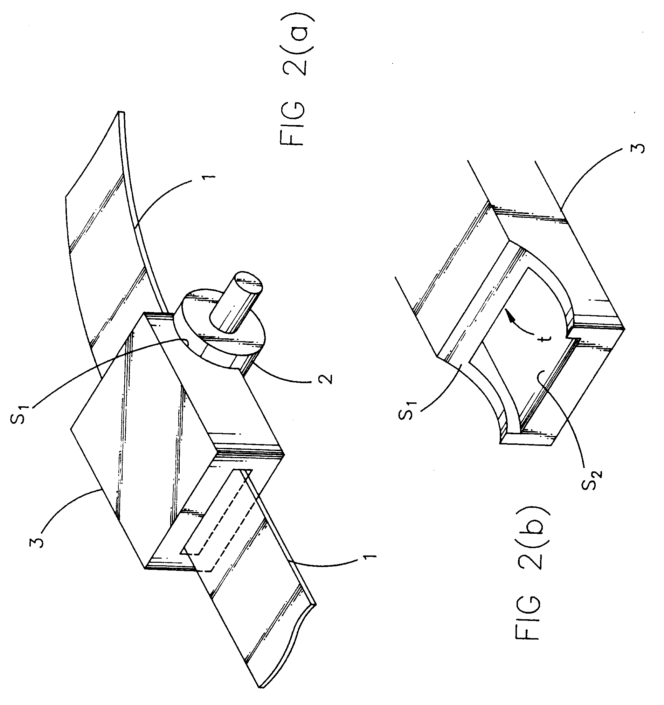

The sealing attachment 3 (Fig. 1) surrounds approximately half of the outer surface of the guide roller 2. It includes a concave arcuate sealing surface $S_1$ shaped to form an extremely small or narrow gap $\delta_1$ with the outer surface of the guide roller 2, except for the inlet region through which the incoming elongated sheet 1 passes. It also includes a further concave arc-shaped sealing surface $S_2$ (Fig. 2) which is shaped to form extremely small gaps $\delta_2$ and $\delta_3$, $\delta_3'$, (Fig. 1); $\delta_3$, $\delta_3'$, with the back surface and the two sides of the elongated sheet 1 in the winding region, and a slit t (Figs. 1 and 2) which has a much larger opening than the cross-sectional dimensions of the elongated sheet 1. The latter opening t is located inside the second concave arc-shaped sealing surface $S_2$ and connected with it, in a direction tangential to the guide roller 2. Its outer appearance is shown in Fig. 2(a), while the concave arc-shaped sealing surfaces $S_1$ and $S_2$ which face the guide roller 2 are shown in an inverted form in Fig. 2(b).

Turning further to the form of the invention shown in Fig. 1, the pressure differences ($P_1$-$P_2$) and ($P_2$-$P_3$) between the differential pressure chambers 4 and 5 and 5 and 6 are much smaller than the above-mentioned pressure difference ($P_0$-$P_1$), and in these chambers roller seals are provided by means of spaced pairs of sealing guide rollers 8, 8 and 9, 9 which have their axes displaced in the direction in which the elongated sheet passes through the apparatus, one being in an upstream position and the other in a downstream position in relation to the direction in which the elongated sheet is moving.

Furthermore, it is unavoidable for $\delta_2$ and $\delta_1$, shown in Fig. 1, to become somewhat too large when the width of the elongated sheet is changed, and it is also suitable to provide auxiliary plates which can move in the axial direction of the roller and are air-tight, so that the gaps can be continuously controlled to be very small.

Since the single guide roller which guides the introduction of the elongated sheet into the apparatus is preferably provided with a sealing attachment 3 (see Figs. 2(a) and 2(b)) which has a concave arcuate sealing surface which is separated only by an extremely small gap from the roller surface, which gap includes the elongated sheet, not only is an effective differential-pressure seal formed, but the elongated sheet is guided on the above-mentioned guide roller at a angle of wrap. Further, since the elongated sheet in this wrap area is attracted and held tightly to the outer surface of the roller 2 it is not possible for strong surface pressure to be applied to the elongated sheet. This would have a harmful effect on the product quality. Nor can vibration, even if present, be applied to the elongated sheet in a manner to cause it to break.

When the elongated sheet 1 is wrapped on the guide roller 2 and passes through the apparatus the product quality sometimes differs simply because of an undesirable angle of wrapping, due to the wrap angle $\theta$ and the tension of the elongated sheet 1; therefore, it is desirable for the wrap contact angle to be limited to the range of 15°-120° and the tension to be set in the range of 0.1-2.0 kg/mm².

The foregoing principles will further be explained on the basis of an actual example in which a TiN coating (0.8 $\mu$m thick) was formed on a silicon steel plate, manufactured under the conditions set forth below, by means of an ion plating treatment using the apparatus of Fig. 1.

The silicon steel sheet used in the actual example was manufactured as follows. A silicon steel slab with the composition shown in Table 1 was heated for 4 hours at 1,340°C after which it was drawn while hot and finished to form a hot drawn sheet 2.0 mm thick. After this, it was cold-drawn twice, with an intermediate annealing for 3 minutes at 950°C between these drawings, and a final cold-drawn sheet 0.23 mm thick was formed. Then, a decarburization primary recrystallization annealing step was performed in moist hydrogen at 830°C, after which an annealing separator agent composed of MgO (35%), $Al_2O_3$ (60%), $TiO_2$ (4%), and $SrSO_4$ (1%) was applied to the surface of the steel sheet, and a secondary recrystallization annealing step was performed for 5 hours at 850°C. After this, a purification annealing step was performed in dry hydrogen at 1,180°C for 8 hours, and the oxide on the surface of the steel sheet was then removed by acid washing. The steel sheet was then finished to a center line mean roughness of Ra = 0.1 $\mu$m by electrolytic polishing.

## Table 1

| C | Si | Mn | Se | Sb | Mo |
|---|----|----|----|----|----|
| 0.043% | 3.36% | 0.72% | 0.022% | 0.025% | 0.013% |

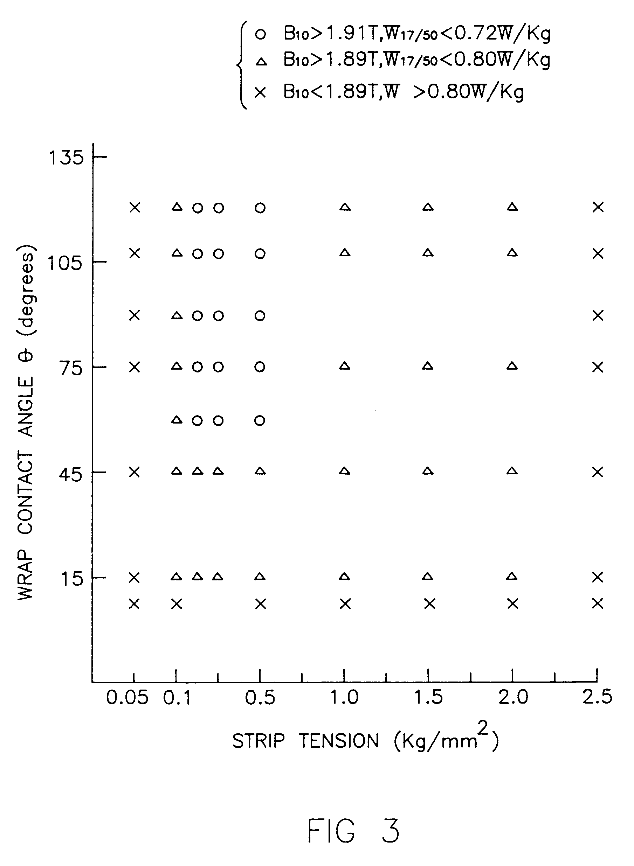

Fig. 3 is a graph showing the effects on the magnetic properties (magnetic flux density $B_{10}$ and the iron loss $W_{17/50}$) of an elongated steel sheet when the wrap contact angle $\theta$ and the tension were varied. The circles indicate excellent magnetic properties, the triangles indicate acceptable properties and the crosses indicate unacceptable properties. It is clear in Fig. 3 that good magnetic properties were shown, as marked by the circles and triangles in the graph, when the wrap contact angle with the guide roller 2 was greater than 15° and preferably greater than 60°, and the tension was in the range of 0.1-2.0 kg/mm², and preferably 0.2-0.5 kg/mm². In contrast to this, when the wrap contact angle $\theta$ was small and the tension on the steel sheet was less than 0.1 kg/mm², the magnetic properties were adversely affected by vibration of the steel sheet when it was conducted to the differential pressure chambers, as marked with crosses in the graph, and breakage and other damage were caused. Moreover, the magnetic properties were also adversely affected when the tension was greater than 2.0 kg/mm², as marked by crosses in the graph.

Furthermore, when the wrap contact angle $\theta$ was greater than 120°, the sealing lengths differed between the upper and lower sealing attachments 3 and the roller, as is clear for example, from Fig. 1, and the amounts of air flowing through the gaps became asymmetrical; therefore, considerable sheet breakage was caused due to unevenness in the steel sheet. For this reason, it is highly desirable for the wrap contact angle $\theta$ to be less than 120°.

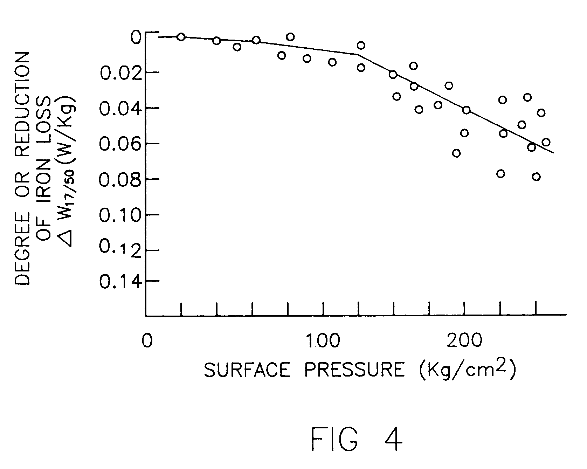

The case of quality deterioration of an elongated sheet which has been tightly compressed by a pair of rollers is shown in Fig. 4, in which, after a grain oriented silicon steel sheet was finished by annealing, its surface oxide was removed and it was polished to a mirror surface with a center line mean roughness Ra = 0.1 $\mu$m; the degree of reduction of iron loss, which depends on the surface pressure exerted by the roller seal in this case, is shown in Fig. 4. As the surface pressure was increased, and in particular when it exceeded 100 kg/cm$^2$, the iron loss reduction was marked. In contrast to this, when this invention was used, a reliable differential pressure seal was achieved by means of a sealing attachment of this invention on a single guide roller, with no possibility of producing excessive surface pressure.

As a further example a TiN coating (0.8 $\mu$m thick) was formed on a silicon steel sheet by ion plating, using a PVD apparatus which incorporated the differential-pressure sealing device shown in Fig. 1, and the magnetic properties of the product obtained were investigated.

The results, together with the conditions prevailing at the time the sheet passed through the apparatus are shown in Table 2.

## Table 2

| | Wrap contact angle θ (degrees) | Tension (kg/mm$^2$) | Magnetic flux density $B_{10}$ (T) | Iron loss $W_{17/50}$ (W/kg) |
|---|---|---|---|---|
| Suitable example | 75 | 0.3 | 1.94 | 0.68 |
| Comparison example | 40 | 3.5 | 1.89 | 0.81 |

The above-mentioned silicon steel sheet was produced as follows. A silicon steel slab with the composition shown in Table 3 was heated for 3 hours at 1,440°C, after which it was rolled while hot and made into a hot-rolled sheet 1.8 mm thick. After this, it was cold-rolled twice, with an intermediate annealing at 1,050°C between these rollings, and a final cold-rolled sheet 0.23 mm thick was formed. Then, a decarburization annealing step was performed in moist hydrogen at 850°C, after which an annealing separator agent composed of MgO (35%) and Al$_2$O$_3$ (65%) was applied to the surface of the steel sheet, and a secondary recrystallization annealing was performed by raising the temperature from 850°C to 1,050°C at 15°C/h. After this a purification annealing step was performed in dry hydrogen at 1,200°C for 8 hours, and the oxide on the surface of the steel sheet was then removed by acid washing. The steel sheet was then finished to a center line mean roughness of Ra=0.1 $\mu$m by electrolytic polishing.

## Table 3

| C | Si | Mn | Al | Se | Mo | N |
|---|---|---|---|---|---|---|
| 0.058% | 3.39% | 0.76% | 0.026% | 0.021% | 0.018% | 0.0078% |

Furthermore, the differential-pressure sealing device according to this invention is also extremely useful when applied to a grain oriented silicon steel sheet and when one is removing oxides after a finishing annealing treatment. It is also particularly useful when a beneficial iron loss reduction of grain oriented silicon steel sheet is obtained by forming a tension film by way of a mixed phase of at least one nitride and/or carbide of Ti, Zr, V, Nb, Ta, Cr, Mo, Co, Ni, Mn, Al, B, or Si and oxides of Al, Ni, Cu, W, Si, or Zn with the base steel by means of dry plating after the sheet passes through the step of mirror finishing of Ra≦0.4 $\mu$m (see JP-A-62-1,820, 62-1,822,).

In particular, this invention can also be applied, of course, in cases in which a super low iron loss is made possible beneficially by the effective use of elastic tension in both steel plate surfaces by dry plating at a temperature of 100°C-1,100°C (see JP-A-62-30,302).

Suitable ranges for the wrap contact angle θ and the tension of the elongated sheet 1 are as started above; however, when the values set are near the lower limits of the above-mentioned ranges, there is in fact a chance that vibration, etc. will be caused in the elongated sheet 1 as it passes through. In such a

EP 0 291 952 B1

case, the suction and tight adhesion of the elongated sheet 1 to the outer surface of the guide roller 2 in the winding region of the roller can be effectively provided.

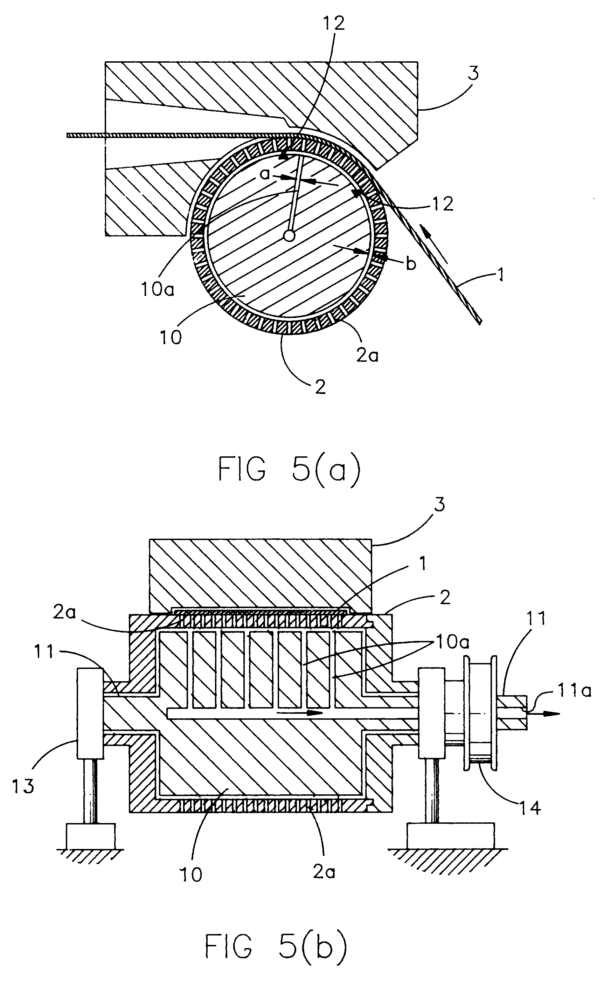

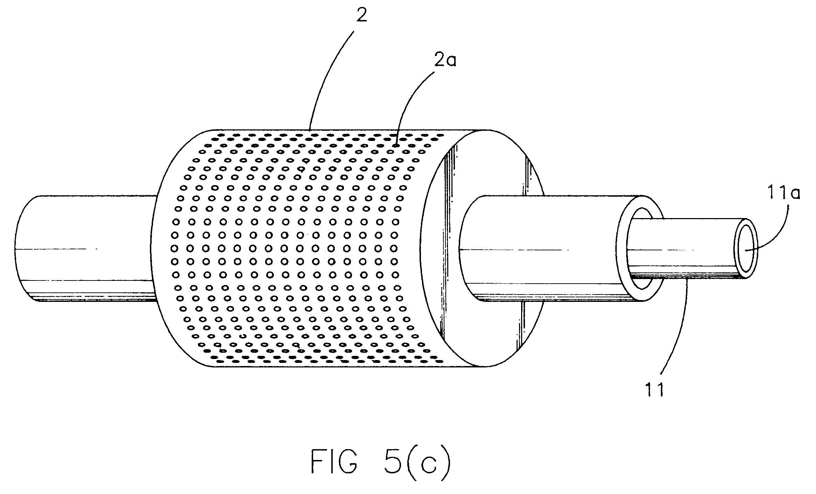

Fig. 5 shows an especially suitable example of the differential-pressure sealing device of this invention in which the single guide roller 2 is a hollow roller with numerous pores 2a extending through its outer surface, and this hollow roller 2 encloses a fixed cylindrical member 10 which has a number of suction openings 10a (see also Fig. 5(b)), which are connected to a suction opening 11a provided in a fixed axle 11 (Fig. 5(b)) which supports the said part 10. The elongated sheet 1 is sucked and held tightly to the outer surface of the roller 2 in the winding region by the operation of a vacuum pump (not shown) during the time the elongated sheet 1 passes through the apparatus.

Furthermore, suitable sizes for the pores 10a in the outer surface of the guide roller 2 are about $0.1\Phi$-$2.0\Phi$ mm. The suction force which sucks and tightly adheres the elongated sheet 1 to the outer surface of the roller is determined by the diameter (a) of the suction openings 10a and the gap (b) formed between the inner surface of the guide roller 2 and the cylindrical part 10 (see Fig. 5(a)). If these are set so that (a)>>(b), the air which is sucked in from holes outside the winding region is negligible. Moreover, in order to provide reliable suction of the elongated sheet 1 in the winding region of the guide roller 2, it is also suitable to apply a sealing material 12 to the surface of the cylindrical part 10.

In this device, it is desirable that the single guide roller 2 consist of a hollow roller and that the inside of the hollow roller be provided with a magnet which attracts the elongated sheet tightly against the outer surface of the roller in the entrance area.

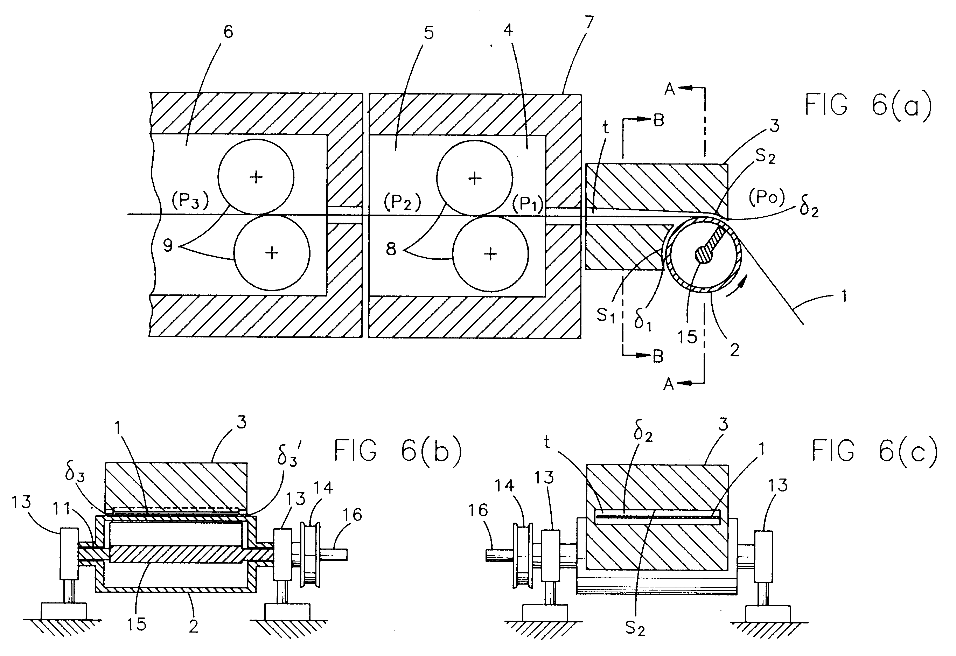

Fig. 6 also shows several spaced areas such as ($P_1$-$P_2$) and ($P_2$-$P_3$) having pressure differences among them. In this figure, the number 1 refers to an elongated sheet moving from right to left as indicated by the arrows. The number 2 refers to a hollow guide roller which guides the elongated sheet 1 as it is conducted into the space 4. 15 is a magnet placed inside the guide roller 2, and 3 is a sealing attachment, which is an important feature of this invention and which is operative in combination with the guide roller 2 whether the roller 2 is hollow or not and whether or not it includes the magnet 15. The numbers 4, 5 and 6 designate differential pressure chambers which are constructed so that the degree of vacuum existing in an any given chamber may be increased from atmospheric pressure $P_0$ to the negative pressures $P_1$, $P_2$, $P_3$ ⋯ increasing in the order of the subscripts, over several spaces with pressure differences, between them, while maintaining the pressure differences continuously as the elongated sheet 1 advances through the treatment method.

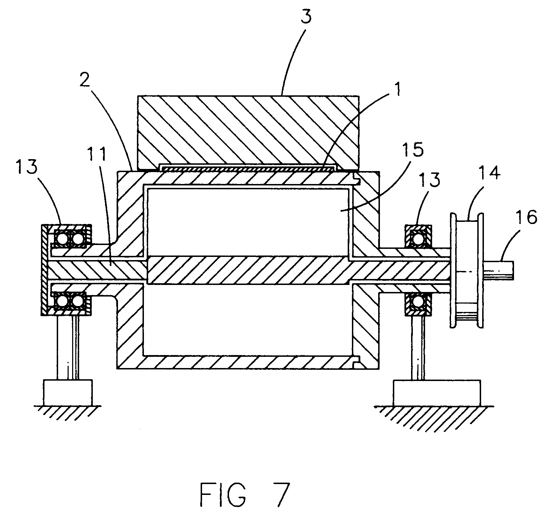

On the inner side of a differential-pressure casing 7, which corresponds to a boundary between pressure regions $P_0$-$P_1$, the guide roller 2, on which the elongated sheet 1 is passed, is supported by a bearing 13 (Figs. 6(b) and 7) so that it can rotate. The magnet 15 is located inside the guide roller 2 (an electromagnet is assumed in this example) and is fixed by means of a support 11, which is connected to a magnetism-controlling electrode 16 connected in the usual way for selectively applying and removing a magnetic field. These parts are arranged so that only the guide roller 2 but not the magnet 15 is rotated by a drive device (which may be a conventional motor or the like, not shown in the drawings), by way of a pulley 14.

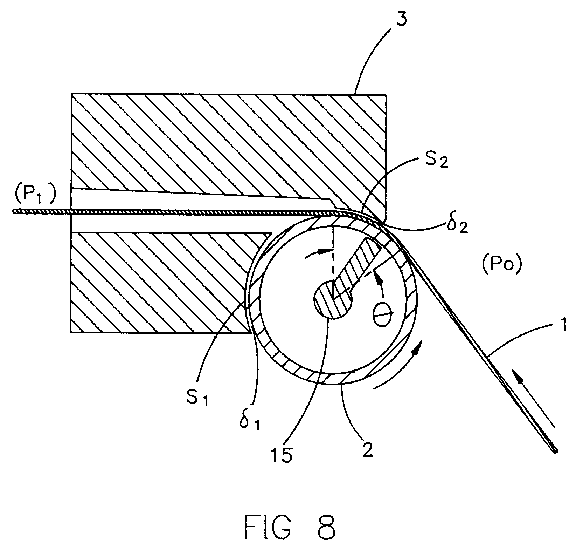

Fig. 7 shows the structure by which the magnet 15 is fixed inside the guide roller 2. The elongated sheet 1 is guided on the outside of guide roller 2, preferably at a shallow wrap contact angle $\theta$ (Fig. 8).

The magnetic force of magnet 15, when it consists of an electromagnet, can be regulated suitably by regulating the current applied. In order for magnet 15 to act effectively on the elongated sheet 1 from within the guide roller 2, the end of the magnet, as shown in Fig. 7, is located adjacent to the inner wall of the guide roller 2 and at a substantially central part of the long dimension of the elongated sheet 1, in the wrap region.

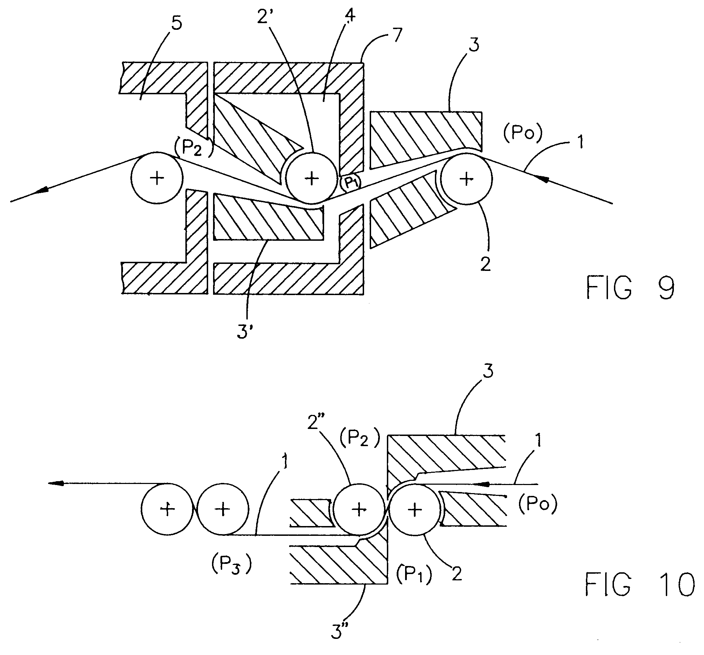

Fig. 9 shows a modified form of the invention in which the high pressure differences from $P_0$ to $P_1$ and from $P_1$ to $P_2$ were achieved more advantageously by twice repeating the differential-pressure seal structure shown in Fig. 1. Fig. 10 shows an example in which the sealing effectiveness is further increased by twice repeating the differential-pressure seal described above, using two differential-pressure sealing devices of this invention placed opposite each other and close to the guide rollers 2 and 2″, and wherein the elongated sheet 1 is not squeezed by or between the rollers 2, 2″.

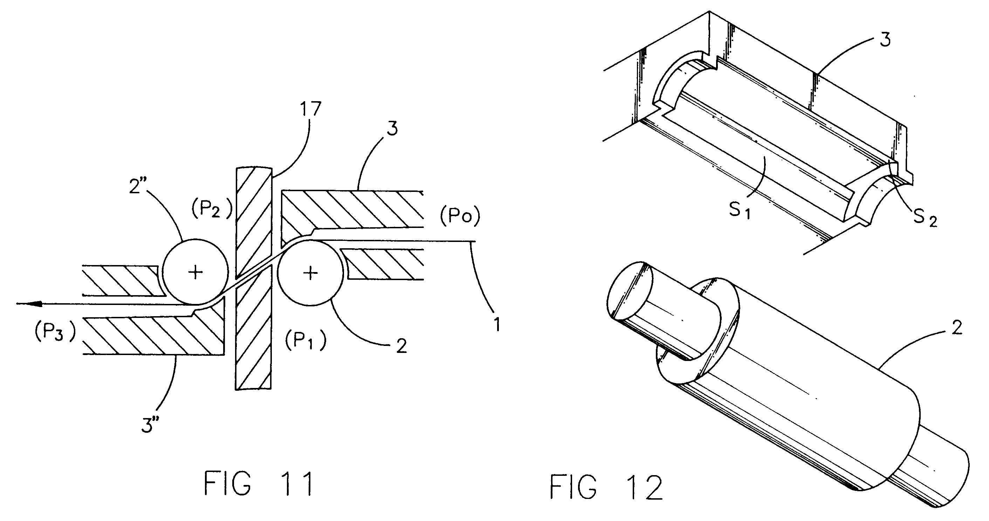

Furthermore, Fig. 11 shows a case in which the sealing effectiveness of the apparatus is increased by repeating the differential-pressure seal twice, using two differential-pressure sealing devices with guide rollers 2 and 2‴ placed opposite each other with a space between them and a plate 17 with a slit 17 inserted between them.

In all of the above-mentioned cases, the differential-pressure sealing device of this invention, by using very small gaps of about 0.01-0.5 mm, was able efficiently to maintain pressure differences of about 1.5-20 fold between adjacent pressure difference chambers when the width of the elongated sheet was, for

6

example, 300-1,200 mm and its thickness was 0.1-0.2 mm.

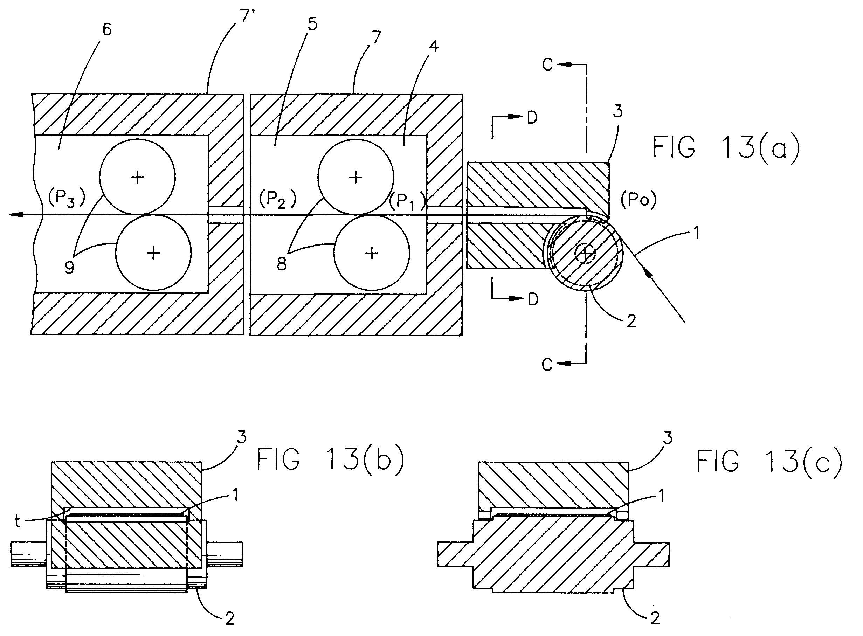

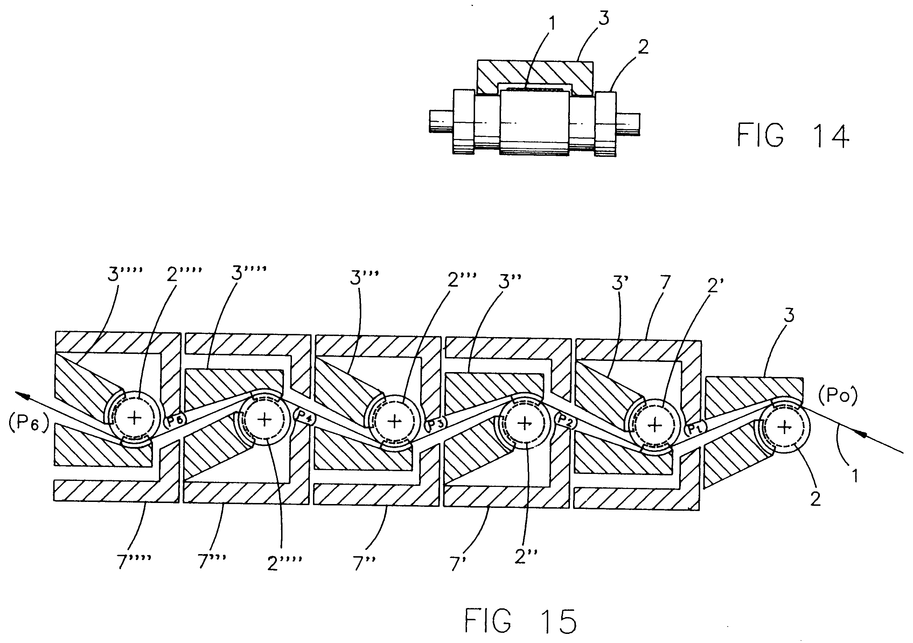

In Fig. 12 an example is shown in which the differential-pressure seals on the sides of the device are increased by covering the end surfaces of the guide roller 2 adjacent to the journals and creating additional differential-pressure seals there, and Figs. 13, 14 show examples in which the differential-pressure seals on the sides of the device are increased further by forming steps or concave portions in the end surfaces of the guide rollers 2 adjacent to the journals and enclosing them, with sealing attachment 3 with shapes which conform to the shapes of these steps or concave parts in order to create additional differential-pressure seals there. Furthermore, in the example shown in Fig. 13, the pressure difference $(P_2-P_3)$ between the pressure difference chambers 4 and 5 and 5 and 6 is much smaller than $(P_0-P_1)$. In the same way as shown in Fig. 1, a roller seal is formed due to a pair of sealing rollers 8 and 9 which substantially completely block the chamber to provide the seal but which do not squeeze the elongated sheet. Rollers 8 and 9 have their axes displaced from one another in the direction in which the sheet passes through the apparatus, one being in an upstream position and the other in a downstream position in relation to the direction of movement of the elongated sheet 1.

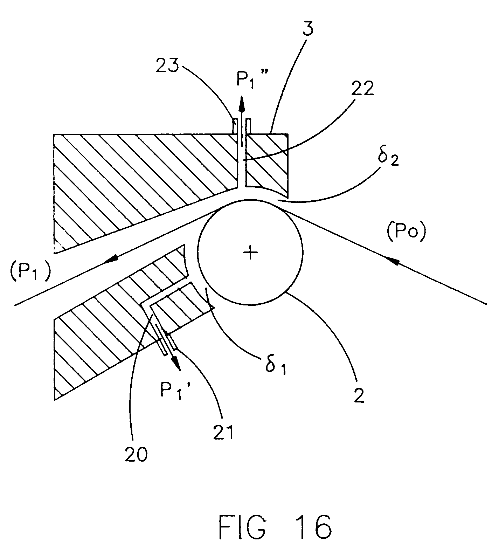

Furthermore, Fig. 15 shows an example in which a large negative pressure difference from $P_0$ to $P_6$ can be achieved more advantageously by repeating the differential-pressure seal shown in Fig. 9 as many as six times.

Fig. 16 shows a further modification of the sealing attachment 3 wherein a vacuum passage 20 and fitting 21 are provided for applying vacuum adjacent the guide roller 2 and the lower surface of the elongated sheet 1 after it has contacted the guide roller 2. A further vacuum passage 22 and fitting 23 are provided for applying a vacuum to the upper surface of elongated sheet 1 as it wraps upon the guide roller 2.

The apparatus according to the invention comprises in its sealing structure a supplemental seal.

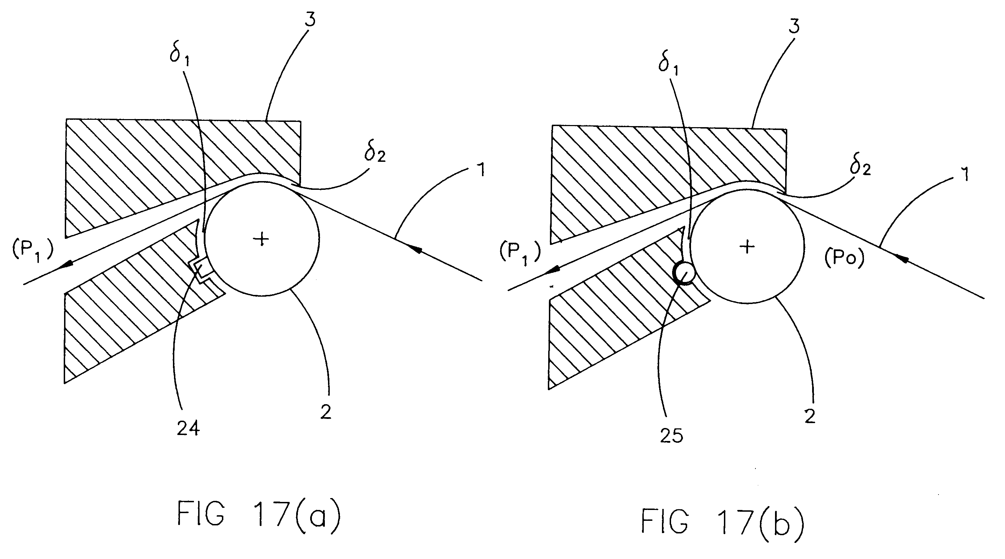

Fig. 17(a) shows a supplemental seal block 24 mounted in a hollow portion and interposed between the guide roller 2 and the lower portion of the sealing attachment 3, out of contact with the surface of the elongated sheet 1, extending at about right angles to the direction of movement of the sheet.

Fig. 17(b) shows a different form of supplemental seal in the form of a roller 25 also mounted in a hollow portion of the sealing attachment 3, and also mounted at about right anglesto the direction of movement of the elongated sheet, like the block 24 of Fig. 17(a), but in many cases being capable of creating a more effective differential pressure.

It will accordingly be appreciated that this invention is directed to a differential-pressure sealing device which connects spaced areas having pressure differences among them, and permits the continuous passage of an elongated sheet while maintaining the pressure differences at the desired levels.

The sealing device according to this invention may include a single guide roller which guides the passage of the elongated sheet, which may be located between the above-mentioned spaced areas and a sealing attachment which is positioned so that it surrounds the elongated sheet with part of one of its opposed surfaces located close to the surface of the sheet of the above-mentioned roller, and shaped in such a way as to conform to the surface of the sheet; part of the other surface of the sealing attachment is positioned close to the outer surface of the above-mentioned roller, and its end is shaped in such a way to conform with the above-mentioned outer surface of the roller. This sealing surface has a side structure which conforms to the above-mentioned outer surface of the roller, the said end is placed close to the outer surface of the above-mentioned roller, and the two above-mentioned opposing parts are connected so that they maintain a substantially air-tight seal. In addition, the above-mentioned single roller is provided, on the inside, with a magnet or on the outer surface, with numerous pores which attracts the winding region of the elongated sheet to the outer surface of the roller and makes it adhere tightly to that surface.

The differential-pressure sealing device of this invention serves effectively to prevent the quality of an elongated sheet from deteriorating due to the surface pressure applied when a high differential-pressure seal is formed, without producing local surface pressure on the elongated sheet, by using only an attachment on a single guide roller, and serves to tightly adhere the elongated sheet which is being wound on the guide roller to the outer surface of the guide roller; in addition, it serves to prevent breakage of the elongated sheet caused by vibration of the elongated sheet or the associated conveyor. It is not only especially suitable for forming dry plating coatings on super-low iron loss grain oriented silicon steel sheets, but it can of course also be applied to soft steel, etc., the quality of which is readily affected by local surface pressures.

Although this invention has been disclosed with specific reference to a variety of forms of apparatus, it will be appreciated that additional variation and deviations may be made without departing from the principles of the invention. The use of magnet as disclosed in Figs. 6-8 or the use of suction as disclosed in Fig. 5 is not necessarily a basic part of the invention. Further, features shown in one of the drawings may be combined with features shown in others of the drawings, parts may be reversed and certain features of the invention used independently with other features of the invention.

**Claims**

1. An apparatus for continuously processing an elongated sheet (1) through successive zones of reduced pressure comprising:

    (a) means forming at least one chamber (4,5,6) containing at least one of said zones of reduced pressure, said chamber having an entrance through which said elongated sheet may be introduced;

    (b) vacuum means connected to maintain reduced pressure in said chamber;

    (c) a guide roller (2) arranged adjacent to said chamber (4) and around which said elongated sheet may be wrapped prior to entering said chamber;

    (d) means (3) forming a sealing structure encompassing at least a portion of said chamber entrance and a portion of said elongated sheet to restrict the passage of said atmoshperic air past said guide roller into said chamber, said sealing structure including an upper portion ($S_2$) located above said guide roller and a lower portion ($S_1$) located adjacent said guide roller below the path of movement of said elongated sheet, and wherein said lower portion includes a supplemental seal (24,25) disposed therein at a location closely adjacent to said guide roller;

    (e) means for wrapping said elongated sheet upon said guide roller; and

    (f) means (2,2a,10a,15) for urging the wrapped portion of said elongated sheet tightly against the wrapped surface of said guide roller.

2. The apparatus as defined in claim 1 wherein the differential-pressure sealing attachment (3) has opposing surfaces ($S_1$,$S_2$) and surrounds the elongated sheet (1) with part of one of its opposing surfaces placed close to the surface of the elongated sheet on said guide roller (2), and is shaped to conform to the surface of the sheet, and wherein part of the other surface of the sealing attachment is placed close to the outer surface of the guide roller, and its end is shaped to confrom with the outer surface of the guide roller, and wherein the sealing attachment has a side structure which conforms to the outer surface of said guide roller and its end is placed close to the outer surface of said guide roller, and wherein both of said opposing surfaces are connected so that they maintain a substantially air-tight seal.

3. The apparatus defined in claim 1, wherein said urging means (f) includes a magnet (15) located within said guide roller (2).

4. The apparatus defined in claim 3, wherein said magnet (15) is an electromagnet.

5. The apparatus defined in claim 3, wherein said magnet (15) is a permanent magnet.

6. The apparatus as defined in claim 1, wherein said guide roller (2) includes a plurality of pores (2a) and wherein said urging means includes a vacuum means communicating with the interior of said guide roller and acting through said pores to suck said elongated sheet (1) against the wrapped surface of said guide roller.

7. The apparatus as defined in claim 1, wherein the angle of wrap of said elongated sheet (1) upon said guide roller (2) is 15-120°.

8. The apparatus as defined in claim 1, wherein a plurality of said zones of reduced pressure is provided in said chamber (4), and wherein passages are provided between said zones for continuous movement of said elongated sheet (1) from zone to zone.

9. The apparatus as defined in claim 1, wherein sealing rollers (8,9) are provded in said zones of reduced pressure.

10. The apparatus as defined in claim 9, wherein said sealing roller (8,9) are arranged in staggered relationship such that the axis of rotation of one sealing roll is positioned upstream of the axis of rotation of the other sealing roll in relation to the direction of movement of said elongated sheet (1).

**11.** The apparatus as defined in claim 1, wherein said sealing structure (3) includes a concave arcuate surface ($S_1$) shaped to form a narrow gap ($S_1$) with the outer surface of said guide roller (2).

**12.** The apparatus as defined in claim 11, wherein said sealing structure (3) is shaped to provide close clearance with the ends of said guide roller (2) in a manner to restrict the flow of air.

**13.** The apparatus as defined in claim 1, wherein said sealing structure (3) includes an arcuate surface ($S_1$) and a slit portion (t) located downstream of said arcuate surface with respect to the direction of movement of said elongated sheet.

**14.** The apparatus as defined in claim 9, wherein said sealing rollers (8,9) have axes that are displaced in the direction of movement of said elongated sheet (1).

**15.** The apparatus as defined in claim 1, wherein a plurality of said chambers (4,5,6) is provided adjacent one another along the direction of movement of said elongated sheet and provided with entrance and exit openings to accommondate passage of said sheet (1), and wherein sealing rollers (8,9) are provided in a plurality of said chambers adjacent to openings therein, thereby increasing their sealing effectiveness.

**16.** The apparatus as defined in claim 15, wherein said sealing rollers (8,9) are arranged close to one of said openings which extends from one chamber to the other, one sealing roller on the upstream side and the other sealing roller on the downstream side of said opening.

**17.** The apparatus as defined in claim 16, wherein said sealing rollers (8,9) are arranged to guide said elongated sheet (1) through an arcuate path.

**18.** The apparatus as defined in claim 17, wherein a plate is provided between said sealing rollers (8,9) and provided with a slit providing a passage for said elongated strip.

**19.** The apparatus as defined in claim 1, wherein sealing rollers (8,9) are provided in said chamber (4,5,6) which are of a size and shape to substantially block flow of air in the direction of movement of said elongated sheet (1).

**20.** The apparatus as defined in claim 1, wherein said guide roller (2) includes a shouldered portion shaped to conform to a corresponding internal shape of said sealing structure.

**21.** The apparatus defined in claim 1, further including supplemental means (22,23) for drawing a vacuum between said sealing structure and said guide roller (2).

**22.** The apparatus defined in claim 21, wherein said sealing structure includes an upper portion (22) located above said guide roller (2) and a lower portion (23) located adjacent said guide roller below the path of movement of said elongated sheet, and wherein said supplemental vacuum means is located in said lower portion of said sealing structure.

**23.** The apparatus defined in claim 22, wherein said supplemental seal block is a roller (25).

**24.** A method of continuously processing an elongated steel sheet, which comprises the steps of:
(a) providing a plurality of successive differential pressure chambers (4,5,6), each chamber having an entrance through which said elongated sheet (1) may be introduced;
(b) applying negative pressure within said chambers;
(c) continuously wrapping said elongated steel sheet around a guide roller (2) for introduction to said chambers;
(d) continuously sealing at least a portion of the entrance of at least one of said chambers (4) and a portion of said elongated steel sheet (1) to restrict the passage of atmospheric air past said guide roller into said chambers;
(e) continuously wrapping said elongated steel sheet upon said guide roller such that the wrap contact angle between said elongated steel sheet and said guide roller is between 15 and 120°; and

(f) continuously urging the wrapped portion of said elongated steel sheet tightly against the wrapped surface of said guide roller such that the tension in said elongated steel sheet is between 0.1 and 2.0 kg/mm$^2$.

**25.** The method defined in claim 24, wherein said urging action is applied by magnetic force.

**26.** The method defined in claim 24, wherein said urging action is applied by vacuum.

**Patentansprüche**

**1.** Vorrichtung zur kontinuierlichen Bearbeitung eines Blechbandes (1) in aufeinanderfolgenden Unterdruckzonen, umfassend:

(a) eine Einrichtung zur Bildung wenigstens einer Kammer (4, 5, 6), die wenigstens eine der Unterdruckzonen umfaßt, wobei die Kammer einen Eingang aufweist, durch den das Blechband einführbar ist;

(b) eine zur Aufrechterhaltung des Unterdrucks in der Kammer verbundene Vakuumeinrichtung;

(c) eine Führungswalze (2), die in der Nähe der Kammer (4) angeordnet, und um bzw. auf welche das Blechband vor dem Eintritt in die Kammer wickelbar ist bzw. aufläuft;

(d) eine Einrichtung (3), die einen Dichtungsaufbau bildet, welcher wenigstens einen Teil des Kammereingangs und einen Teil des Blechbandes einschließt, um den Durchgang von atmosphärischer Luft hinter der Führungswalze in die Kammer zu verhindern, wobei der Dichtungsaufbau einen oberhalb der Führungswalze angeordneten oberen Abschnitt ($S_2$), und einen in der Nähe der Führungswalze unter dem Bewegungsweg des Blechbandes angeordneten unteren Abschnitt ($S_1$) umfaßt, und wobei der untere Abschnitt eine Ergänzungsdichtung (24, 25) umfaßt, die innenliegend an einer Stelle nahe der Führungswalze angeordnet ist;

(e) eine Einrichtung zum Aufwickeln bzw. -laufen des Blechbandes auf die Führungswalze; und

(f) eine Einrichtung (2, 2a, 10a, 15), die den aufgelaufenen Abschnitt des Blechbandes eng gegen die gekrümmte Oberfläche der Führungswalze zwingt.

**2.** Vorrichtung nach Anspruch 1, wobei die Differentialdruck-Dichtungsvorrichtung (3) gegenüberliegende Flächen ($S_1$, $S_2$) aufweist und das Blechband (1) mit einem Teil einer seiner gegenüberliegenden Flächen, der sich in der Nähe der Oberfläche des Blechbandes an der Führungswalze (2) befindet, umgibt und konform zur Fläche des Bleches geformt ist, und wobei ein Teil der äußeren Oberfläche des Dichtungsanbaus in der Nähe der äußeren Oberfläche der Führungswalze angeordnet ist, und ihr Ende konform mit der äußeren Oberfläche der Führungswalze geformt ist, und wobei der Dichtungsanbau einen seitlichen Aufbau aufweist, der konform zur äußeren Oberfläche der Führungswalze ist und dessen Ende in der Nähe der äußeren Oberfläche der Führungsfläche angeordnet ist, und wobei beide der gegenüberliegenden Flächen verbunden sind, so daß sie eine im wesentlichen luftdichte Dichtung aufrechterhalten.

**3.** Vorrichtung nach Anspruch 1, wobei die Einrichtung zum Zwingen (f) einen Magneten (15) umfaßt, der innerhalb der Führungswalze (2) angeordnet ist.

**4.** Vorrichtung nach Anspruch 3, wobei der Magnet (15) ein Elektromagnet ist.

**5.** Vorrichtung nach Anspruch 3, wobei der Magnet (15) ein Permanentmagnet ist.

**6.** Vorrichtung nach Anspruch 1, wobei die Führungswalze (2) eine Vielzahl von Poren (2a) umfaßt, und wobei die Zwangseinrichtung eine Vakuumeinrichtung umfaßt, die mit dem Inneren der Führungsrolle in Verbindung steht und über die Poren wirkt, so daß das Blechband (1) gegen die gekrümmte Oberfläche der Führungswalze ansaugbar ist.

**7.** Vorrichtung nach Anspruch 1, wobei der Auflaufwinkel des Blechbandes (1) auf die Führungswalze (2) 15 bis 210° ist.

**8.** Vorrichtung nach Anspruch 1, wobei eine Mehrzahl Unterdruckzonen in der Kammer (4) vorgesehen sind, und wobei Passagen zwischen den Zonen zur kontinuierlichen Bewegung des Blechbandes (1) von Zone zu Zone vorgesehen sind.

9. Vorrichtung nach Anspruch 1, wobei Dichtungswalzen (8, 9) in den Unterdruckzonen vorgesehen sind.

10. Vorrichtung nach Anspruch 9, wobei die Dichtungswalzen (8, 9) in versetzter Beziehung angeordnet sind, so daß die Drehachse einer Dichtungswalze im Verhältnis zur Bewegungsrichtung des Blechbandes (1) stromaufwärts gegenüber der Drehachse der anderen Dichtungswalze angeordnet ist.

11. Vorrichtung nach Anspruch 1, wobei der Dichtungsaufbau eine konkave, gewölbte Oberfläche ($S_1$) umfaßt, die so geformt ist, daß sie einen engen Spalt ($S_1$) mit der äußeren Oberfläche der Führungswalze (2) bildet.

12. Vorrichtung nach Anspruch 11, wobei der Dichtungsaufbau (3) so geformt ist, daß er einen engen Zwischenraum mit den Enden der Führungswalze (2) bereitstellt, so daß ein Luftstrom beschränkbar ist.

13. Vorrichtung nach Anspruch 1, wobei der Dichtungsaufbau (3) eine gewölbte Oberfläche ($S_1$) und einen Schlitzabschnitt (t) umfaßt, der stromabwärts der gewölbten Oberfläche bezüglich der Bewegungsrichtung des Blechbandes angeordnet ist.

14. Vorrichtung nach Anspruch 9, wobei die Dichtungswalzen (8, 9) Achsen aufweisen, die in Bewegungsrichtung des Blechbandes (1) versetzt sind.

15. Vorrichtung nach Anspruch 1, wobei eine Mehrzahl der Kammern (4, 5, 6) einander benachbart entlang der Bewegungsrichtung des Blechbandes vorgesehen und mit Eingangs- und Ausgangsöffnungen versehen sind, um für den Durchgang des Bleches (1) angepaßt zu sein, und wobei Dichtungswalzen (8, 9) in der Mehrzahl der Kammern in der Nähe der hierin befindlichen Öffnungen vorgesehen sind, so daß dadurch ihre Dichtungswirkung vergrößert wird.

16. Vorrichtung nach Anspruch 15, wobei die Dichtungswalzen (8, 9) in der Nähe einer der sich von einer Kammer zur anderen erstreckenden Öffnungen angeordnet sind, wobei eine Dichtungswalze an der stromaufwärtigen Seite und die andere Dichtungswalze auf der stromabwärtigen Seite der Öffnung angeordnet ist.

17. Vorrichtung nach Anspruch 16, wobei die Dichtungswalzen (8, 9) so angeordnet sind, daß sie das Blechband (1) durch einen gewölbten Weg führen.

18. Vorrichtung nach Anspruch 17, wobei eine Platte zwischen den Dichtungswalzen (8, 9) vorgesehen ist, die mit einem Schlitz versehen ist, der einen Durchgang für das Blechband zur Verfügung stellt.

19. Vorrichtung nach Anspruch 1, wobei die in der Kammer (4, 5, 6) vorgesehenen Dichtungswalzen (8, 9) eine Größe und Form aufweisen, so daß ein Luftstrom in Bewegungsrichtung des Blechbandes (1) im wesentlichen blockiert wird.

20. Vorrichtung nach Anspruch 1, wobei die Führungswalze (2) einen Schulterabschnitt umfaßt, der konform mit einer korrespondierenden inneren Form des Dichtungsaufbaus geformt ist.

21. Vorrichtung nach Anspruch 1, des weiteren umfassend eine Ergänzungseinrichtung (22, 23) zum Aufbauen eines Vakuums zwischen dem Dichtungsaufbau und der Führungswalze (2).

22. Vorrichtung nach Anspruch 21, wobei der Dichtungsaufbau einen oberhalb der Führungswalze (2) angeordneten, oberen Abschnitt (22) umfaßt, und einen in der Nähe der Führungswalze unterhalb des Bewegungswegs des Blechbandes angeordneten, unteren Abschnitt (23) umfaßt, und wobei die Ergänzungsvakuumeinrichtung im unteren Abschnitt des Dichtungsaufbaus angeordnet ist.

23. Vorrichtung nach Anspruch 22, wobei der Ergänzungsdichtungsblock eine Walze (25) ist.

24. Verfahren zur kontinuierlichen Bearbeitung eines Blechbandes, welches die folgenden Schritte umfaßt:
(a) Vorsehen einer Mehrzahl aufeinanderfolgender Differentialdruckkammern (4, 5, 6), wobei jede Kammer einen Eingang aufweist, durch welchen das Blechband (1) einführbar ist;
(b) Aufbringen eines Unterdruckes innerhalb der Kammern;

(c) kontinuierliches Auflaufen bzw. Wickeln des Stahlblechbandes an bzw. um eine Führungswalze (2) zur Einführung in die Kammern;

(d) kontinuierliches Abdichten wenigstens eines Eingangsabschnitts von wenigstens einer der Kammern (4) und eines Abschnitts des Stahlblechbandes (1), um den Durchgang atmosphärischer Luft hinter die Führungswalze in die Kammer zu verhindern;

(e) kontinuierliches Auflaufen des Stahlblechbandes auf die Führungswalze, so daß der Wickel- bzw. Auflaufkontaktwinkel zwischen dem Stahlblechband und der Führungswalze zwischen 15 und 120° ist; und

(f) kontinuierliches Zwingen des gewickelten Abschnittes des Stahlblechbandes eng gegen die gebogene Oberfläche der Führungswalze, so daß die Spannung im Stahlblechband zwischen 0,1 und 2,0 kg/mm$^2$ ist.

25. Verfahren nach Anspruch 24, wobei der Vorgang des Zwingens durch magnetische Kraft hervorgerufen wird.

26. Vorrichtung nach Anspruch 24, wobei der Vorgang des Zwingens durch Vakuum hervorgerufen wird.

**Revendications**

1. Appareil pour traiter en continu une feuille allongée (1) le long de zones succesives à pression réduite comprenant:

(a) un moyen constituant au moins une chambre (4, 5, 6) contenant au moins une desdites zones à pression réduite, ladite chambre ayant une entrée au travers de laquelle ladite feuille allongée peut être introduite;

(b) un moyen pour faire le vide branché en vue de créer une pression réduite dans ladite chambre:

(c) un tambour de guidage (2) monté de manière adjacente à ladite chambre (4) et autour duquel ladite feuille allongée peut être roulée avant de pénétrer dans ladite chambre;

(d) un moyen (3) formant une structure d'étanchéité enveloppant au moins une partie de ladite entrée de chambre et une partie de ladite feuille allongée pour réduire le passage de l'air ambiant dans ladite chambre au travers dudit tambour de guidage, ladite structure d'étanchéité comprenant une partie supérieure (S$_2$) située au-dessus du tambour de guidage et une partie inférieure (S$_1$) placée à côté du tambour de guidage en-dessous de la trajectoire suivie par le déplacement de la feuille allongée, et dans laquelle structure, ladite partie inférieure comporte un joint étanche supplémentaire (24, 25) placé à l'intérieur de ladite portion inférieure dans un endroit situé juste à côté dudit tambour de guidage;

(e) un moyen d'enrouler ladite feuille allongée sur ledit tambour de guidage; et

(f) des moyens (2, 2a, 10a, 15) pour forcer ladite portion enroulée de ladite feuille allongée serrée contre ladite face en contact d'enroulement dudit tambour de guidage.

2. Appareil selon la revendication 1, dans lequel l'accessoire d'étanchéité à pression différentielle (3) comporte des faces qui s'opposent (S$_1$, S$_2$) et entoure la feuille allongée (1) avec une partie de l'une de ses faces qui s'opposent placée contre la face de la feuille allongée sur ledit tambour de guidage (2) et a un profil qui épouse la face de la feuille allongée, et dans lequel une partie de l'autre face dudit accessoire d'étanchéité est placée contre la face extérieure du tambour de guidage et son extrémité épouse la forme de la face extérieure du tambour de guidage, et dans lequel ledit accessoire d'obturation étanche comporte une structure latérale qui épouse la forme de la face extérieure dudit tambour de guidage et dont l'extrémité est placée contre la face extérieure dudit tambour de guidage, et dans lequel lesdites faces opposées sont en contact de façon à ce qu'elles forment un joint substantiellement étanche à l'air.

3. Appareil selon la revendication 1, dans lequel lesdits moyens pour forcer (f) comportent un aimant (15) situé à l'intérieur dudit tambour de guidage (2).

4. Appareil selon la revendication 3, dans lequel ledit aimant (15) est un électro-aimant.

5. Appareil selon la revendication 3, dans lequel ledit aimant (15) est un aimant permanent.

6. Appareil selon la revendication 1, dans lequel ledit tambour de guidage (2) comporte une pluralité de pores (2a) et dans lequel lesdits moyen de forcer (f) comportent un moyen de faire le vide communiquant avec l'intérieur dudit tambour de guidage et agissant au travers des pores pour aspirer ladite feuille allongée (1) contre la face d'enroulement dudit tambour de guidage.

7. Appareil selon la revendication 1, dans lequel l'angle d'enroulement de ladite feuille allongée (1) par rapport audit tambour de guidage (2) est de 15 à 120°.

8. Appareil selon la revendication 1, dans lequel plusieurs zones à pression réduite sont prévues dans ladite chambre (4), et dans lequel des passages sont prévus entre lesdites zones pour assurer un déplacement continu de ladite feuille allongée (1) de zone en zone.

9. Appareil selon la revendication 1, dans lequel des cylindres d'étanchéité (8, 9) sont prévus dans lesdites zones à pression réduite.

10. Appareil selon la revendication 9, dans lequel lesdits cylindres d'étanchéité (8, 9) sont disposés en quinconce de façon à ce que l'axe de rotation d'un cylindre d'étanchéité soit placé en amont de l'axe de rotation de l'autre cylindre d'étanchéité par rapport à la direction de déplacement de ladite feuille allongée (1).

11. Appareil selon la revendication 1, dans lequel ladite structure d'étanchéité (3) comporte une face concave arquée ($S_1$) dont la forme a été étudiée de façon à laisser un léger intervalle ($S_1$) par rapport à la face extérieure dudit tambour de guidage (2).

12. Appareil selon la revendication 11, dans lequel ladite structure d'étanchéité (3) a une forme étudiée pour laisser un jeu très faible par rapport aux extrémités dudit tambour de guidage (2) de façon à réduire le flux d'air.

13. Appareil selon la revendication 1, dans lequel ladite structure d'étanchéité (3) comporte une face de forme arquée ($S_1$) et une partie fendue (t) située en aval de ladite surface arquée par rapport à la direction de déplacement de ladite feuille allongée.

14. Appareil selon la revendication 9, dans lequel lesdits cylindres d'étanchéité (8, 9) ont des axes qui sont décalés par rapport à la direction de déplacement de ladite feuille allongée (1).

15. Appareil selon la revendication 1, dans lequel plusieurs desdites chambres (4, 5, 6) sont prévues et sont placées les unes contre les autres dans la direction de déplacement de ladite feuille allongée et comportent des orifices d'entrée et de sortie pour permettre le passage de ladite feuille allongée (1), et dans lequel lesdits cylindres d'étanchéité (8, 9) sont prévus dans une pluralité desdites chambres contre lesdits orifices desdites chambres, pour améliorer ainsi l'efficacité de l'étanchéité.

16. Appareil selon la revendication 15, dans lequel lesdits cylindres d'étanchéité (8, 9) sont placés très près d'un desdits orifices qui assure la communication d'une chambre à une autre, un cylindre d'étanchéité étant placé du côté amont dudit orifice et l'autre cylindre d'étanchéité étant placé du côté aval dudit orifice.

17. Appareil selon la revendication 16, dans lequel lesdits cylindres d'étanchéité (8, 9) sont aménagés pour guider ladite feuille allongée (21) le long d'une trajectoire arquée.

18. Appareil selon la revendication 17, dans lequel une plaque est prévue entre lesdits cylindres d'étanchéité (8, 9) et laquelle plaque comporte une fente pour le passage de ladite bande allongée.

19. Appareil selon la revendication 1, dans lequel les cylindres d'étanchéité (8, 9) sont placés dans ladite chambre (4, 5, 6) et dont la dimension et la forme ont été étudiées pour bloquer substantiellement le flux d'air dans la direction de déplacement de la feuille allongée (1).

20. Appareil selon la revendication 1 ci-dessus, dans lequel ledit tambour de guidage (2) comporte une partie épaulée dont la forme épouse une forme intérieure correspondante de ladite structure d'étanchéité.

21. Appareil selon la revendication 1, comportant en outre un moyen supplémentaire (22, 23) pour créer du vide entre ladite structure d'étanchéité et ledit tambour de guidage (2).

22. Appareil selon la revendication 21, dans lequel ladite structure d'étanchéité comporte une partie supérieure (22) placée au-dessus dudit tambour de guidage (2) et une partie inférieure (23) placée à côté dudit tambour de guidage en-dessous de la trajectoire de déplacement de ladite feuille allongée, et dans lequel ledit moyen supplémentaire de créer le vide est placé dans ladite portion inférieure de ladite structure d'étanchéité.

23. Appareil selon la revendication 22, dans laquelle ledit bloc d'étanchéité supplémentaire est un cylindre (25).

24. Méthode de traitement continu d'une feuille allongée, comprenant les phases suivantes:
(a) prévoir plusieurs chambres successives à pression différentielle (4, 5, 6), chacune desdites chambres ayant une entrée par laquelle ladite feuille allongée (1) peut être introduite;
(b) application d'une pression négative à l'intérieur des chambres;
(c) enroulement continu de ladite feuille d'acier allongée autour dudit tambour de guidage (2) pour introduction dans lesdites chambres;
(d) étanchéité continue d'au moins une partie de l'entrée d'au moins une desdites chambres (4) et d'une partie de ladite feuille d'acier allongée (1) pour réduire le passage de l'air ambiant au travers dudit tambour de guidage dans lesdites chambres;
(e) enroulement continu de ladite feuille d'acier allongée sur ledit tambour de guidage de façon à ce que l'angle de contact d'enroulement entre la dite feuille d'acier allongée et ledit tambour de guidage soit compris entre 15° et 120°; et
(f) application continue forcée et serrée de ladite partie enroulée de ladite feuille d'acier allongée contre la face enroulée du tambour de guidage de façon à ce que la tension à l'intérieur de ladite feuille d'acier allongée soit comprise entre 0,1 et 2,0 kg/mm$^2$.

25. Méthode selon la revendication 24, dans laquelle ladite action d'application forcée de ladite partie enroulée est effectuée par une force magnétique.

26. Méthode selon la revendication 24, dans laquelle ladite action d'application forcée de ladite partie enroulée est effectuée sous l'action du vide.

FIG 1(a)

FIG 1(b)

FIG 1(c)

FIG 2(a)

FIG 2(b)

$\begin{cases} \circ & B_{10}>1.91T, W_{17/50}<0.72W/Kg \\ \triangle & B_{10}>1.89T, W_{17/50}<0.80W/Kg \\ \times & B_{10}<1.89T, W >0.80W/Kg \end{cases}$

FIG 3

17

FIG 4

FIG 5(a)

FIG 5(b)

FIG 5(c)

FIG 6(a)

FIG 6(b)

FIG 6(c)

EP 0 291 952 B1

FIG 7

FIG 8

FIG 9

FIG 10

FIG 11

FIG 12

EP 0 291 952 B1

FIG 13(a)

FIG 13(b)

FIG 13(c)

FIG 14

FIG 15

FIG 16

FIG 17(a)

FIG 17(b)

EP 0 291 952 B1